(19) Europäisches Patentamt
European Patent Office
Office européen des brevets

(11) **EP 3 879 642 B1**

(12) **EUROPÄISCHE PATENTSCHRIFT**

(45) Veröffentlichungstag und Bekanntmachung des Hinweises auf die Patenterteilung:
**24.09.2025 Patentblatt 2025/39**

(21) Anmeldenummer: **20162911.0**

(22) Anmeldetag: **13.03.2020**

(51) Internationale Patentklassifikation (IPC):
*H01S 5/12* (2021.01)          *H01S 5/065* (2006.01)
*H01S 5/125* (2006.01)          *H01S 5/22* (2006.01)
*H01S 5/34* (2006.01)

(52) Gemeinsame Patentklassifikation (CPC):
**H01S 5/1237; H01S 5/125;** H01S 5/0654;
H01S 5/22; H01S 5/3401

(54) **MONOMODIGER HALBLEITERLASER MIT PHASENKONTROLLE**

SINGLE MODE SEMICONDUCTOR LASER WITH PHASE CONTROL

LASER SEMI-CONDUCTEUR MONOMODE À COMMANDE DE PHASE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.09.2021 Patentblatt 2021/37**

(73) Patentinhaber: **Advanced Photonics Applications GmbH**
**97218 Gerbrunn (DE)**

(72) Erfinder:
• **KOSLOWSKI, Tim**
**97199 Ochsenfurt (DE)**
• **KOSLOWSKI, Nicolas**
**97070 Würzburg (DE)**

(74) Vertreter: **advotec.**
**Patent- und Rechtsanwaltspartnerschaft mbB**
**Beethovenstraße 5**
**97080 Würzburg (DE)**

(56) Entgegenhaltungen:
EP-A1- 1 283 571          WO-A1-2005/124951
JP-A- 2001 291 929          US-A1- 2017 299 822

• **YU NANFANG ET AL: "Quantum cascade lasers with integrated plasmonic antenna-array collimators", OPTICS EXPRESS, vol. 16, no. 24, 10 November 2008 (2008-11-10), pages 19447, XP055971685, Retrieved from the Internet <URL:https://www.researchgate.net/profile/ Masamichi-Yamanishi/publication/23493931_Qu antum_cascade_lasers_with_integrated_plasmo nic_antenna-array_collimators/links/ 0fcfd508495f00d34a000000/ Quantum-cascade-lasers-with-integrated-plas monic-antenna-array-collimators.pdf> [retrieved on 20220916], DOI: 10.1364/OE.16.019447**
• **BUKHARI SYED S. ET AL: "A Metasurfaces Review: Definitions and Applications", APPLIED SCIENCES, vol. 9, no. 13, 1 July 2019 (2019-07-01), pages 2727, XP055971679, ISSN: 2076-3417, DOI: 10.3390/app9132727**
• **KADIC MUAMER ET AL: "3D metamaterials", NATURE REVIEWS, PHYSICS, 31 January 2019 (2019-01-31), pages 198 - 210, XP055961778, Retrieved from the Internet <URL:https://www. nature.com/articles/s42254-018-0018-y> [retrieved on 20220916], DOI: 10.1038/ s42254-018-0018-y**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft ein Verfahren zur Herstellung eines Halbleiterlasers gemäß dem Oberbegriff des Anspruchs 1. Ferner betrifft die vorliegende Erfindung einen Halbleiterlaser gemäß des Oberbegriffs des Anspruchs 9.

Halbleiterlaser sind nach dem aktuellen Stand der Technik eine weitverbreitete Technologie zur Erzeugung kohärenter elektromagnetischer Strahlung mit jeweils für die Anwendung optimierten Eigenschaften. Die Anwendungsgebiete umfassen insbesondere die Telekommunikation, die Analyse und die Sensorik. Eine Vielzahl dieser Anwendungen benötigt monomodige Halbleiterlaser mit einer präzise einstellbaren, eingestellten oder vorgegebenen Wellenlänge der elektromagnetischen Strahlung. Darüber hinaus werden üblicherweise weitere Anforderungen an die Strahlungsquelle hinsichtlich der elektro-optischen Eigenschaften, wie beispielsweise bezüglich der Ausgangsleistung, dem Durchstimmbereich der Wellenlänge oder der Höhe der Seitenmodenunterdrückung gestellt. Grundlegendes Funktionsprinzip der Halbleiterlaser ist das Prinzip der stimulierten Emission. Bei dieser wird das Licht einer Mode oder Schwingungsmode exponentiell verstärkt, wenn sie im Verstärkungsspektrum des Lasermediums liegt und die Verluste minimiert werden. In einem Halbleiterlaser existieren ohne zusätzliche Anpassungen oder weitere Maßnahmen zunächst eine Vielzahl von sogenannten Fabry-Perot-Moden, welche im Bereich der Verstärkung zu stimulierter Emission angeregt werden können. Somit resultiert zunächst grundsätzlich ein breites Emissionsspektrum eines Halbleiterlasers.

Ein aus dem Stand der Technik bekannter Ansatz, um von dem grundsätzlich breiten Emissionsspektrum zu dem geforderten monomodigen Betrieb eines Halbleiterlasers zu gelangen, offenbart beispielsweise die EP 0 984 535 B1. Darin ist ein Halbleiterlaser vorgesehen, der neben einem Wellenleitersteg ein parallel zum Wellenleitersteg angeordnetes periodisches Gitter, insbesondere Metallgitter, aufweist. Die Gitterperiode, das heißt die Abstände vom Beginn eines Gitterstegs bis zum Beginn des nächsten Gitterstegs, wird als die halbe Wellenlänge, insbesondere die halbe effektive Wellenlänge der gewünschten Lasermode, eingestellt. Bei der effektiven Wellenlänge handelt es sich um die Wellenlänge im Material. Das Gittermaterial wird dabei so gewählt, dass eine Variation des Brechungsindex in der Umgebung der Gitterstäbe erzeugt wird, um so eine periodische Modulation des effektiven komplexen Brechungsindex festzulegen.

Durch die periodische Modulation des Brechungsindex wird eine starke Wellenlängenabhängigkeit der Verluste oder der Absorption herbeigeführt. Die periodische Variation des Absorptionskoeffizienten führt zusätzlich zu Verlusten mit starker Abhängigkeit von der Wellenlänge. Mit dieser Technologie lässt sich eine weitgehende Einschränkung oder Reduzierung der verstärkten oder verstärkbaren Moden bereits erreichen. Mit anderen Worten ausgedrückt bedeutet dies, dass sich durch die periodische Struktur oder Lateralstruktur, die nicht zwangsläufig periodisch ausfallen muss, eine Grundauswahl der durch stimulierte Emission verstärkten oder verstärkbaren Lasermoden erreichen lässt.

In der Druckschrift EP 1 283 571 A1 ist eine weitere Ausführungsform eines Lasers mit Wellenleitersteg und einer Lateralstruktur mit periodischer Modulation des effektiven komplexen Brechungsindex offenbart. Dabei ist die Lateralstruktur schwach mit dem Wellenleitersteg gekoppelt, um in einer hohen Anzahl an Gitterstrukturelementen Interferenzeffekte hervorzurufen und auf diese Weise die Seitenmodenunterdrückung bei gleichzeitiger hoher Abgabeleistung zu steigern.

Aus der Druckschrift JP 2001 291929 A ist eine weitere Ausführungsform eines Lasers mit einer Gitterstruktur aus Materialen unterschiedlicher Brechungsindizes, welche sich auf dem Wellensteg erstreckt, bekannt. Die Gitterstruktur wird dabei bevorzugt aus den Metallen Titan und Gold hergestellt.

Die Druckschrift US 2017/0299822 A1 offenbart ein optisches Transmissionselement mit einer darin angeordneten Gitterstruktur bestehend aus Materialien unterschiedlicher Brechungsindizes für einen Laser. Mit dem optischen Transmissionselement wird die Wellenlänge des Lichts des Lasers stabilisiert, die Temperaturabhängigkeit des Lasers reduziert und die Kontrollierbarkeit des Lasers erhöht.

Ferner offenbart die Druckschrift WO 2005/124951 A1 ein Verfahren zur Herstellung eines Halbleiters und ein Halbleiter gemäß dem Oberbegriff der Ansprüche 1 und 9.

Es war bei dem bekannten Ansatz jedoch in der Vergangenheit noch nicht möglich, mit hoher Reproduzierbarkeit entsprechend der theoretischen Erwartungen einen echt monomodigen Betrieb von Halbleiterlasern bei den angestrebten Wellenlängen zu erreichen, wobei bisher auch unbekannt war, weshalb mit der vorangehend beschriebenen Technologie ein tatsächlich monomodiger Betrieb des Halbleiterlasers mit der angestrebten Wellenlänge und Betriebsparametern nicht immer erreicht werden konnte.

Diese Situation führt jedoch allgemein zu dem Nachteil, dass bei der bekannten Herstellung oder bei bekannten Herstellungsverfahren für gattungsgemäße Halbleiterlaser ein verhältnismäßig großer Anteil an Ausschuss produziert wurde, nämlich gerade die Halbleiterlaser, die trotz entsprechender Lateralstrukturen oder periodischen Strukturen zur Modulation des Brechungsindex gerade keine echt monomodigen Ausgangsspektren bei der angestrebten Wellenlänge erzielten.

Vor diesem Hintergrund stellt sich die vorliegende Erfindung die Aufgabe, einen Halbleiterlaser sowie ein Verfahren zur Herstellung eines Halbleiterlasers vorzuschlagen, die die Nachteile im Stand der Technik überwinden und insbesondere eine vorhersehbare und zuverlässige Herstellung von echten oder tatsächlich monomodigen Halbleiterlasern erlauben.

Gelöst wird diese Aufgabe durch ein Herstellungsverfahren mit den Merkmalen des Anspruchs 1. Weiter wird diese Aufgabe mit einem Halbleiterlaser mit den Merkmalen des Anspruchs 9 gelöst. Vorteilhafte Ausführungsformen sind Gegenstand der Unteransprüche.

Gelöst wird diese Aufgabe durch ein Verfahren zur Herstellung eines Halbleiterlasers, welches das Aufbringen einer Mehrschichtstruktur auf einem Halbleitersubstrat vorsieht, wobei die Schichten der Mehrschichtstruktur parallel zu einer durch eine Oberfläche des Halbleitersubstrats definierten Schichtausbreitungsebene verlaufen und wobei das Aufbringen der Mehrschichtstruktur zumindest das Erzeugen einer aktiven Region umfasst. Ferner ist im Rahmen des Verfahrens in an sich bekannter Weise vorgesehen, dass durch ein Abtragen von Material der Mehrschichtstruktur in zumindest zwei voneinander getrennten Materialabtragsbereichen, wobei der Materialabtrag im Wesentlichen senkrecht zur Schichtausbreitungsebene erfolgt, ein Wellenleitersteg gebildet wird. Ebenfalls in grundsätzlich bekannter Weise umfasst das Verfahren die Erzeugung einer Isolationsschicht auf zumindest den Materialabtragsbereichen sowie das Erzeugen einer Lateralstruktur, zumindest in den Materialabtragsbereichen, durch welche eine Grundauswahl der durch stimulierte Emission verstärkten oder verstärkbaren Lasermoden erfolgt. Weiter ist in dem Verfahren ebenfalls in grundsätzlich bekannter Weise das Erzeugen von senkrecht zur Schichtausbreitungsebene in Längsrichtung des Wellenleiters an einem Kavitätsende oder an zwei gegenüberliegenden Kavitätsenden angeordneten Facettenschichtstrukturen zur Reflexion und/oder Auskopplung von Laserstrahlung vorgesehen.

Gemäß der vorliegenden Erfindung sieht das Verfahren zudem einen Verfahrensschritt zur Erzeugung eines optischen Elements zur Definition der Phasenlage der verstärkten oder verstärkbaren Lasermoden vor, wobei das Erzeugen des optischen Elements die Ausbildung von meta-optischen Metallstrukturen auf einer der Facettenschichtstrukturen umfasst und wobei das optische Element derart erzeugt wird, dass in Längsrichtung des Wellenleiterstegs der Abstand so eingestellt wird, dass die Phasenlage zwischen der Lateralstruktur und dem optischen Element besser als $\pi/4$ kontrolliert werden kann. Daraus folgt, dass für den Abstand d gilt:

$$\min|d - m \cdot \lambda_{\mathrm{eff}}/2| \leq \lambda_{\mathrm{eff}}/4.$$

Hierbei ist m eine natürliche Zahl ( $m \in \mathbb{N}$ ) und $\lambda_{\mathrm{eff}}$ die effektive Wellenlänge im Material.

Erfindungsgemäß ist also vorgesehen, dass das optische Element mit einer präzisen Anordnung oder mit einem präzisen Abstand gegenüber dem Ende der Lateralstrukturschicht angeordnet wird und zudem dazu geeignet ist die Phasenlage der verstärkbaren oder verstärkten Lasermoden einzustellen, so dass im Endeffekt nur noch genau eine Lasermode verstärkt wird oder verstärkt werden kann und dementsprechend ein echt monomodiger Betrieb des Halbleiterlasers zuverlässig erzeugt oder erreicht werden kann. Wie der obigen Bedingung entnommen werden kann, gibt es dabei eine Vielzahl von möglichen Abständen, die das Kriterium erfüllen können und somit zur Definition der erfindungsgemäßen Phasenlage dienen können. Dies erleichtert in besonderer Weise die Realisierung der Erfindung, da je nach Art und Weise, mit der das optische Element erzeugt wird, ein entsprechender Abstand gemäß der Bedingung gewählt und das optische Element erzeugt werden kann.

Wie nachfolgend noch genauer erläutert werden wird, gibt es grundsätzlich unterschiedliche Möglichkeiten oder unterschiedliche Wirkungsweisen, mit denen das optische Element Einfluss auf die Phasenlage der verstärkten Lasermoden ausüben kann. Grundsätzlich ist jedoch die Beeinflussung der Phasenlage mit der Beeinflussung des effektiven Brechungsindex der Laserkavität verknüpft. Dies bedeutet im Umkehrschluss, dass das optische Element dazu geeignet ist oder dazu geeignet sein muss, den effektiven Brechungsindex der Laserkavität als Ganzes zu beeinflussen.

Diese Beeinflussung des effektiven Brechungsindex kann durch periodische Strukturen erreicht werden. Wie nachfolgend jedoch noch ausführlich erläutert werden wird, können auch andere Maßnahmen und damit einhergehende oder optisch wirksame Strukturen den gewünschten Einfluss ausüben.

Bei dem effektiven Brechungsindex der Laserkavität handelt es sich um eine globale Eigenschaft der Laserkavität, die sich aus der Lösung der Wellengleichung oder Wellengleichungen der Laserkavität ergibt. Mit anderen Worten ausgedrückt bedeutet dies, dass durch die präzise Positionierung des optischen Elements mit einem Abstand d zur Lateralstruktur, insbesondere einem Ende der Lateralstruktur, für den gilt $\min|d - m \cdot \lambda_{\mathrm{eff}}/2| \leq \lambda_{\mathrm{eff}}/4$ unter Berücksichtigung der Auswirkung des optischen Elements auf den effektiven Brechungsindex der gesamten Laserkavität eine Modenselektion auf genau eine Lasermode erreicht werden kann. Dies bedeutet auch, dass zur Realisierung der erfindungsgemäßen optischen Elemente die Wellengleichung für die Laserkavität die Eigenschaften des optischen Elements mitbestimmt oder vorgibt.

Im Rahmen der Lösung der besagten Wellengleichung des Lasers kann einerseits die entsprechende gewünschte Wirkung des optischen Elements auf den effektiven Brechungsindex bestimmt werden, andererseits kann daraus auch eine Erklärung für die bisher nicht zuverlässige Herstellung von monomodigen Halbleiterlasern gefunden werden.

Denn im bisherigen Stand der Technik wurden die Kanten der Halbleiterlaser im gewissen Rahmen ungenau gebrochen oder gespalten, so dass eine insgesamt verhältnismäßig ungenaue Gesamtlänge der Laserkavität gegeben war. Diese Ungenauigkeit hinsichtlich der Länge der Laserkavität von etwa +/- 15 Mikrometern führte zu einem unbestimmten Abstand zwischen der Lateralstruktur oder dem periodischen Gitter zur Grundauswahl der verstärkten Lasermoden einerseits und der die Kavitätslänge definierenden Facette andererseits. Dieser undefinierte Abstand war durch die oben genannte Ungenauigkeit nicht immer im Bereich $\min|d - m \cdot \lambda_{eff}/2| \leq \lambda_{eff}/4$. Folglich blieb die Phasenlage der verstärkbaren Lasermoden gemäß des oben genannten Stands der Technik unkontrolliert und andere Moden als die gewünschte Lasermode konnten, basierend auf Schwebungseffekten, welche nicht genau der durch die Lateralstrukturschicht oder das wellenlängenselektive Element beabsichtigten Mode entsprechen, verstärkt werden. Dies führte zu der im Stand der Technik vorherrschenden nicht präzisen oder nicht zuverlässigen Modenselektion.

Die Schwebungseffekte, die durch die genaue Phasenlage aufgrund des erfindungsgemäßen optischen Elements und/oder durch die genaue Positionierung des optischen Elements verhindert oder unterdrückt werden, sind hoher Wahrscheinlichkeit nach auf die Floquet-Theorie zurückzuführen, die als mathematische Grundlage des Bloch-Theorems besagt, dass die Lösungen der Wellengleichung oder Modengleichung als Superposition von einer rechts- und einer linkslaufenden Welle dargestellt werden können, die je nach Kavitätseigenschaften und Randbedingungen, insbesondere in Form der Facetten, nicht nur zu den gewünschten stationären stehenden Wellen, sondern auch zu stehenden Wellen mit einer Schwebung führen können. Es wird hierbei vermutet, dass die derartigen Schwebungen oder Schwebungsfrequenzen der Grund oder zumindest ein wesentlicher Grund für die bis dato unzufriedenstellende oder zumindest nicht verlässlich reproduzierbare Herstellung monomodiger Halbleiterlaser darstellt.

Durch das erfindungsgemäße Verfahren und insbesondere durch die Erzeugung und Positionierung des optischen Elements zur Definition der Phasenlage und des effektiven Brechungsindex der verstärkten oder verstärkbaren Lasermoden wird jedoch die besagte Schwebung verhindert oder unterdrückt, so dass zuverlässig monomodige Halbleiterlaser hergestellt werden können.

Mit anderen Worten ausgedrückt bedeutet dies, dass durch die erfindungsgemäße Erzeugung des optischen Elements eine durch die Lateralstrukturschicht, insbesondere durch das periodische Gitter, getroffene Vorauswahl oder Grundauswahl an verstärkten oder verstärkbaren Moden durch die genaue Definition der Phasenlage der Moden im Resonator oder in der Laserkavität weiter präzisiert oder bestimmt wird, mit dem Ergebnis, dass im Endeffekt nur noch genau eine Lasermode mit einer gewünschten Wellenlänge verstärkt und ausgekoppelt wird.

Die erfindungsgemäße Beabstandung des optischen Elements vom Ende einer Lateralstrukturschicht oder einem die Grundauswahl an Moden bedingenden periodischen Gitter sorgt dabei auch für eine ausreichend präzise Bestimmung oder Festlegung der Kavitätslänge der Laserkavität.

Gemäß einer ersten, vorteilhaften Ausführungsform des Verfahrens kann vorgesehen sein, dass das optische Element zusammen mit der Ausbildung der Facettenschichtstruktur erzeugt wird oder im Anschluss an die Ausbildung der Facettenschichtstruktur auf dieser erzeugt wird. Auch kann das optische Element selbst als Facettenschichtstruktur ausgebildet werden. Damit kann grundsätzlich vorgesehen sein, dass das optische Element senkrecht zur Schichtausbreitungsebene keinen oder nur einen teilweisen Überlapp mit der besagten Lateralstrukturschicht aufweist. Denn bei einer Aufbringung des optischen Elements oder einer Ausbildung des optischen Elements im Rahmen der Ausbildung der Facettenschichtstruktur oder im Anschluss an die Ausbildung der Facettenschichtstruktur kann beispielsweise vorgesehen sein, dass das optische Element in Bereichen der Mehrschichtstruktur auf der Facette ausgebildet wird, die senkrecht zur Schichtausbreitungsebene unterhalb der Lateralstruktur angeordnet ist. Trotz alldem soll der erfindungsgemäße Abstand des optischen Elements zum Ende der Lateralstrukturschicht in Längsrichtung eines Wellenleiterstegs durch entsprechende Abstände definiert sein, die Ebenen betreffen, die einerseits parallel zu der jeweiligen Facette und damit senkrecht zur Schichtausbreitungsebene und gleichermaßen senkrecht zur Längsrichtung oder zumindest im Wesentlichen senkrecht zur Längsrichtung des Wellenleiterstegs verlaufen.

Bei der Ausbildung des optischen Elements zusammen oder im Anschluss an die Ausbildung der Facettenschichtstruktur oder als Facettenschichtstruktur gibt es grundsätzlich unterschiedliche Möglichkeiten oder Optionen, wie nachfolgend noch genauer erläutert werden wird. Wichtig ist, wie oben bereits ausgeführt, dass nicht nur der Abstand d präzise genug kontrolliert wird, sondern auch durch das optische Element die gewünschte Phasenlage über eine entsprechende Einstellung des effektiven Brechungsindex der Laserkavität erreicht wird.

Bei der Ausbildung der optischen Elemente zusammen mit der Facettenschichtstruktur oder auf der Facettenschichtstruktur kann vorteilhaft ausgenutzt werden, dass die die Grobauswahl bewerkstelligende Lateralstrukturschicht des Halbleiterlasers in der Regel ohne Probleme bis an eine Bruch- oder Spaltkante eines Halbleiter-Lasers oder einer entsprechenden Laserschichtstruktur heran ausgebildet werden kann, so dass die erfindungsgemäße Positionierung des optischen Elements in einem Abstand d mit der Präzision von $\min|d - m \cdot \lambda_{eff}/2| \leq \lambda_{eff}/4$ - oder beispielsweise für m=1 von höchstens der halben Wellenlänge, insbesondere von weniger als der halben effektiven Wellenlänge, ohne Weiteres möglich ist, selbst wenn beispielsweise zunächst auf einer entsprechend gespalteten oder gebrochenen Facette eine Facettenschichtstruktur ausgebildet oder abgeschieden wird. Denn derartige Facettenschichtstrukturen können in der Regel mit einer Gesamtstärke oder mit einer Gesamtschichtstärke von weniger als der halben effektiven Wellenlänge des Halbleiterlasers ausgebildet werden. Die Facettenschichtstrukturen sind üblicherweise einige 10 bis einige 100 Nanometer stark.

In einer besonders bevorzugten Ausgestaltung des Verfahrens kann vorgesehen sein, dass das optische Element durch eine Variation von Schichten und/oder Schichteigenschaften von Schichten der Facettenschichtstruktur erzeugt wird, die ansonsten zur Optimierung und/oder Einstellung einer Laserschwelle oder einer Ausgangsleistung vorgesehen sind. Mit dieser Verfahrensführung kann in besonders vorteilhafter Weise erreicht werden, dass die Facettenschichtstruktur nicht nur die Funktion zur Einstellung oder Optimierung der Laserschwelle und/oder zur Einstellung oder Optimierung der Ausgangsleistung gewährleistet, sondern darüber hinaus gleichzeitig auch als Ganzes oder zumindest zum Teil als optisches Element im Sinne der vorliegenden Erfindung wirkt. Dazu kann oder muss es dann notwendig sein, die Facettenschichtstruktur sowohl hinsichtlich der sonstigen Lasereigenschaften als auch im Hinblick auf die Wirkung als optisches Element zu optimieren oder einen entsprechenden Kompromiss zu finden, bei dem jedoch zumindest auch eine Wirkung als erfindungsgemäßes optisches Element gewährleistet wird.

Die vorangehend beschriebene Ausführungsform ist insbesondere auch deshalb vorteilhaft, weil dadurch eine effektive Verfahrensführung zur Herstellung der erfindungsgemäßen Halbleiterlaser ermöglicht wird. Denn durch den Umstand, dass für viele Halbleiterlaser eine Facettenbeschichtung mit einer Facettenschichtstruktur üblicherweise erfolgt, kann bei einer kombinierten Ausbildung einer Facettenschichtstruktur zusammen mit einem erfindungsgemäßen optischen Element auf möglicherweise zusätzliche Verfahrensschritte verzichtet werden. Stattdessen kann es ausreichen, die Schichteigenschaften und/oder die Schichtfolgen, die zur Erzeugung der Facettenschichtstruktur sowieso vorgesehen sind, so zu verändern, dass neben einer entsprechenden Beeinflussung der Laserschwelle und/oder der Ausgangsleistung auch eine erfindungsgemäße Definition der Phasenlage der verstärkten Lasermoden bei gleichermaßen erfindungsgemäßem Abstand des optischen Elements von der Lateralstrukturschicht ermöglicht wird.

In einer weiteren, besonders vorteilhaften Variante des erfindungsgemäßen Verfahrens kann vorgesehen sein, dass die Erzeugung des optischen Elements die Ausbildung von meta-optischen Metallstrukturen umfasst. Derartige meta-optische Metallstrukturen mit geeigneten Resonanzeigenschaften eignen sich gut zur Beeinflussung des effektiven Brechungsindex der Gesamtlaserkavität. Gleichzeitig lassen sich derartige meta-optische Metallstrukturen durch das im Grunde nach bekannte Verfahren mit ausreichender Präzision erzeugen. Dadurch kann in vorteilhafter Weise eine entsprechende Beeinflussung der Phasenlage der verstärkbaren Lasermoden erreicht werden. Als Beispiel für etwaige Strukturen sei auf N. Yu et al., Optics Express volume 16, issue 24, page 19447 (2008) verwiesen.

Außerdem kann vorgesehen sein, dass die Erzeugung des optischen Elements die Ausbildung von metallischen und/oder organischen dreidimensionalen Strukturen umfasst, die bevorzugt in einem Zwei-Photonen-Polymerisationsverfahren selektiv aus einer flüssigen oder viskosen Vorstufe verfestigt werden. Sowohl die Ausbildung von meta-optischen Metallstrukturen als auch die Ausbildung von metallischen und/oder organischen dreidimensionalen Strukturen erfolgt besonders bevorzugt auf einer entsprechenden Facettenschichtstruktur unter Einhaltung des erfindungsgemäßen Abstands von der Lateralstrukturschicht, insbesondere vom Ende der Lateralstrukturschicht. Die Verfahren zur Herstellung solcher dreidimensionaler Strukturen, bevorzugt im Rahmen eines Zwei-Photonen-Polymerisationsverfahrens, können entsprechend feine Strukturen mit ausreichender Präzision bereitstellen, die ihrerseits wiederum zur Beeinflussung der Phasenlage oder zur Beeinflussung des effektiven Brechungsindex der Gesamtlaserkavität dienen können. Ebenfalls vorteilhaft kann vorgesehen sein, dass die Erzeugung des optischen Elements die Ausbildung von dielektrischen und/oder Spiegel-Schichtstrukturen, unter Berücksichtigung der Beeinflussung der Phasenlage der verstärkten oder verstärkbaren Lasermoden, umfasst. Die besagten optischen Schichtstrukturen, nämlich die elektrischen Schichtstrukturen oder Spiegel-Schichtstrukturen, sind an sich bekannt und weitverbreitet und können daher mit entsprechender Genauigkeit und zuverlässig bzw. mit hoher Reproduzierbarkeit hergestellt werden. Besondere Voraussetzung ist jedoch, dass gemäß der vorliegenden Erfindung die entsprechenden Schichtstrukturen nicht nur zur Verspiegelung oder Entspiegelung als solches herangezogen werden, sondern im Hinblick auf ihre Eigenschaft im Hinblick auf die Definition der Phasenlage zusammen mit der Lateralstrukturschicht ausgewählt oder ausgebildet werden. Dies bedeutet, dass die erfindungsgemäße Bedingung des Abstands d zum Ende der Lateralstrukturschicht gerade dafür sorgt, dass das optische Element in Phase mit der Lateralstrukturschicht ist und somit die Modenselektion zu einer einzigen Mode gewährleistet. Dies gilt ganz allgemein für das optische Element und für andere oder ähnliche Typen von Spiegeln oder Reflexionselementen. Gleichermaßen sind die sonstigen Wirkungen, beispielweise die Wirkungen als Spiegel- oder Reflexionselement, bei der Konstruktion oder bei der Dimensionierung der gesamten Halbleiterlaseranordnung oder Halbleiterlaserdiode zu berücksichtigen. Beispielsweise kann ein DBR-Element (distributed bragg reflector) vorgesehen sein. Dieses kann auch im Bereich der Materialabtragsbereiche und/oder des Wellenleiterstegs angeordnet sein. Alternativ kann auf einer Facettenschichtstruktur ein exakt phasenangepasster dielektrischer Spiegel ausgebildet werden.

Auch die Beeinflussung der Facette als solches zur Ausbildung des optischen Elements kann vorgesehen sein. Beispielsweise können die erfindungsgemäßen Eigenschaften und damit das optische Element auch durch einen Ätzvorgang zur Bearbeitung der Facetten erzielt werden.

Als Alternative zu einer Ausbildung des optischen Elements senkrecht zur Schichtausbreitungsebene, insbesondere parallel zu einer Facettenschichtstruktur, kann es auch sinnvoll sein, das optische Element mit einer Erstreckung oder Ausbreitung im Wesentlichen oder zumindest auch parallel zur Schichtausbreitungsebene vorzusehen oder auszubilden.

Dementsprechend sieht eine vorteilhafte Ausführungsform, wie oben bereits angedeutet, vor, dass das optische Element im Bereich der Mehrschichtstruktur, bevorzugt im Bereich des Wellenleitersteg oder im Bereich zwischen einem Wellenleitersteg und einem Kavitätsende, ausgebildet wird.

Dadurch kann beispielsweise der Vorteil erreicht werden, dass das optische Element bereits ausgebildet werden kann, bevor die Halbleiterlaser aus einem eine Vielzahl von Halbleiterlasern aufweisenden Verbund, insbesondere einem entsprechenden Wafer, vereinzelt werden. Gleichermaßen ist es dann vorteilhaft möglich für eine in einem Verbund vorliegende Vielzahl von Halbleiterlasern eine entsprechend Vielzahl von optischen Elementen gleichzeitig oder simultan durch entsprechende Verfahrensschritte auszubilden.

In diesem Fall kann es vorteilhaft sein, wenn die Lateralstrukturschicht oder das die Grundauswahl der Moden bereitstellende Element, insbesondere Gitter oder Lateralstrukturschicht, nicht bis zu einem Ende einer Laserkavität oder einer später teilvereinzelten oder vereinzelten Laserkavität ausgebildet wird. Denn dadurch kann das optische Element als längendefinierendes Element des Lasers oder der Laserkavität zusätzlich zu seiner phasendefinierenden Wirkung fungieren, wobei ebenfalls für die erfindungsgemäße Einhaltung des Abstands d zwischen optischem Element einerseits und Ende der Lateralstruktur gesorgt werden muss.

Eine Ausbildung des optischen Elements im Bereich der Mehrschichtstruktur, bevorzugt im Bereich des Wellenleitersteg oder im Bereich zwischen einem Wellenleitersteg und einem Kavitätsende hat auch den Vorteil, dass dadurch sogar gezielt ein Abstand zwischen dem Ende der Lateralstruktur und dem ursprünglichen oder gegenständlichen Kavitätsende herbeigeführt wird. Dies kann unabhängig vom erfindungsgemäßen Wirken des optischen Elements zusätzlich auch einen vorteilhaften Effekt auf das Fernfeld des Halbleiterlasers ausüben.

Gemäß einer besonders bevorzugten Ausführungsform kann beispielsweise vorgesehen sein, dass die Erzeugung des optischen Elements die Ausbildung eines aktiven oder passiven Phasensegments umfasst, welches bevorzugt auf oder an dem Wellenleitersteg ausgebildet wird. Als Phasensegmente können unter anderem aktive oder passive Heizelemente vorgesehen sein, die über einen elektrischen oder ohmschen Heizeffekt oder die entsprechende Wärmeentwicklung aufgrund eines Stromflusses eine Erwärmung der Umgebung im Halbleiterlaser bewirken, die dann ihrerseits zu einer Beeinflussung des effektiven Brechungsindex und damit zu einer Definition der Phasenlage der verstärkten Lasermoden führt. Ein aktives Phasensegment kann beispielsweise eine separat ansteuerbare elektrische Versorgung aufweisen und/oder eine entsprechende separate Kontaktierung aufweisen. Bei einem passiven Phasensegment kann beispielsweise eine Bestromung und eine Heizwirkung oder Wärmeentwicklung aufgrund des Laser-Pumpstroms ausgenutzt werden, um zumindest auch gezielt eine Wärmeentwicklung oder Erwärmung zu verursachen. Durch die entsprechende Anordnung des Phasensegments kann neben der gezielten Beeinflussung des effektiven Brechungsindex auch der erfindungsgemäß benötigte Abstand zum Ende der Lateralstrukturschicht eingehalten werden.

Alternativ kann beispielsweise auch ein Phasensegment unter Ausnutzung des Kerr-Effekts realisiert werden.

Eine Ausbildung des optischen Elements im Bereich der Mehrschichtstruktur, bevorzugt im Bereich des Wellenleitersteg oder im Bereich zwischen einem Wellenleitersteg und einem Kavitätsende, beispielsweise in einer Art unterbrochenen oder direkten Fortsetzung des Wellenleitersteg unter Einhaltung des Abstands d vom Ende der Lateralstrukturschicht, hat auch den Vorteil, dass dadurch sogar gezielt ein Abstand zwischen dem Ende der Lateralstruktur und dem ursprünglichen oder gegenständlichen Kavitätsende herbeigeführt wird. Dies kann unabhängig vom erfindungsgemäßen Wirken des optischen Elements zusätzlich auch einen vorteilhaften Effekt auf das Fernfeld des Halbleiterlasers ausüben.

Eine weitere vorteilhafte Ausführungsform des Verfahrens kann vorsehen, dass das optische Element durch Ionenimplantation in die Mehrschichtstruktur ausgebildet wird. Dabei wird bevorzugt auch eine Ionenimplantation in die aktive Region vorgenommen. Weiter bevorzugt, kann die Ionenimplantation in einem Bereich stattfinden, der in der Schichtausbreitungsebene zwischen einem Ende eines Wellenleitersteg und einem ursprünglichen oder gegenständlichen Ende der Laserkavität oder des Halbleiterlasers angeordnet ist.

Weiter kann vorteilhaft vorgesehen sein, dass das optische Element durch die Erzeugung photonischer Kristalle in der Mehrschichtstruktur ausgebildet wird. Bevorzugt kann vorgesehen sein, dass die Strukturen, insbesondere die Löcher, die den photonischen Kristall bilden, durch den gesamten epitaktischen Aufbau des Halbleiters bis zu einer Pufferschicht hin strukturiert werden, wobei jedoch Variationen zur Einstellung der Kopplungsstärke möglich sind.

Ebenfalls kann vorteilhaft vorgesehen sein, dass das optische Element durch die Erzeugung photonisch integrierter Schaltkreise ausgebildet wird. Die Elemente, die den photonisch integrierten Schaltkreis ausbilden, können dazu beispielsweise im Anschluss, also in Längsrichtung, an einen Wellenleiter und damit zwischen das Ende eines Wellenleiters und das physische oder gegenständliche Ende des Lasers oder der Laserkavität in einen Teil oder in die gesamte Mehrschichtstruktur strukturiert, insbesondere geätzt, werden. Es ist dabei möglich, dass zum Beispiel ein Teil eines unteren Claddings oder einer unteren Cladding-Schicht bewusst unangetastet oder unstrukturiert bleibt. Das optische Element kann dabei zum Beispiel die Form eines Kreises oder einer geschlossenen Kurve aufweisen.

Weiterhin kann vorteilhaft vorgesehen sein, dass eine Vielzahl von Halbleiterlasern benachbart zueinander oder angrenzend aneinander auf einem gemeinsamen Halbleitersubstrat, insbesondere Wafer, ausgebildet werden und eine an die Ausbildung anschließende Vereinzelung des Halbleiterlasers, bevorzugt über eine Bildung einer Array- oder Matrixanordnung mit mehreren nebeneinander angeordneten und miteinander verbundenen Halbleiterlasern, insbesondere durch einen geeignetes Vereinzelungsverfahren, erfolgt.

Wie oben bereits angedeutet kann dabei einerseits vorteilhaft vorgesehen sein, dass die Ausbildung des optischen Elements für mehrere nebeneinander angeordnete Halbleiterlaser, bevorzugt für alle Halbleiterlaser einer gemeinsamen Array- oder Matrixanordnung zusammen, insbesondere gleichzeitig, erfolgt. Dies gilt sowohl für die Ausbildung des optischen Elements im Bereich der Facette oder im Bereich der Facettenschichtstruktur, als auch hinsichtlich der Ausbildung des optischen Elements im Bereich des Wellenleiterstegs oder im Bereich der Materialabtragsbereiche, insbesondere mit einer Ausbreitung parallel zur Schichtausbreitungsebene. Besonders bevorzugt kann vorgesehen sein, dass die Ausbildung des optischen Elements vor einer Vereinzelung von Gruppen von Halbleiterlasern oder von Gruppen von Halbleiterlaserkavitäten erfolgt. Die Gruppen können dann jeweils für einen Betrieb von einzelnen Halbleiterlasern oder den Verbundbetrieb von mehreren Halbleiterlasern vorgesehen sein oder sich zu solchen Betriebsarten eignen.

Im Hinblick auf den Halbleiterlaser wird die oben genannte Aufgabe durch einen Halbleiterlaser mit einer Mehrschichtstruktur umfassend zumindest einen Wellenleitersteg und an den Wellenleitersteg seitlich angrenzenden Materialabtragsbereich, wobei die Mehrschichtstruktur auf einem Halbleitersubstrat angeordnet ist und wobei durch eine Oberfläche des Halbleitersubstrats eine Schichtausbreitungsebene definiert wird, wobei die Mehrschichtstruktur zumindest eine aktive Region aufweist, und wobei die aktive Region eine Schicht- oder Materialstruktur zur Ausbildung einer Laserschicht auf der Grundlage des Prinzips der stimulierten Emission aufweist, und wobei ferner zumindest in den Materialabtragsbereichen, bevorzugt auf einer Isolationsschicht, eine Lateralstrukturschicht vorgesehen ist, durch die eine Grundauswahl der durch stimulierte Emission verstärkten oder verstärkbaren Lasermoden erfolgt, und wobei senkrecht zur Schichtausbreitungsebene in Längsrichtung des Wellenleiterstegs an einem Kavitätsende oder an zwei gegenüberliegenden Kavitätsenden Facettenschichtstrukturen zur Reflexion und/oder Auskopplung von Laserstrahlung ausgebildet sind, dadurch gelöst, dass der Halbleiterlaser ein optisches Element zur Definition der Phasenlage der verstärkten oder verstärkbaren Lasermoden aufweist, wobei das optische Element in Längsrichtung des Wellenleiterstegs einen Abstand d zur Lateralstrukturschicht, der die Bedingung $\min|d - m \cdot \lambda_{eff}/2| \leq \lambda_{eff}/4$ erfüllt, und dass das optische Element auf einer der Facettenstrukturschichten angeordnete meta-optische Metallstrukturen aufweist.

Durch das erfindungsgemäße optische Element wird dadurch einerseits eine definierte Kavitätslänge des Halbleiterlasers erreicht oder anders ausgedrückt, es wird vermieden, dass in Längsrichtung des Wellenleiterstegs ein Bereich gebildet wird oder vorliegt, in dem eine mangelnde Phasendefinition die Entstehung oder Verstärkung von Schwebungsmoden begünstigt oder verursacht. Weiterhin wird neben oder zusätzlich zur Definition der Kavitätslänge auch eine Definition der Phasenlage der verstärkten oder verstärkbaren Lasermoden vorgenommen, so dass das optische Element insgesamt eine von der Lateralstrukturschicht bereits eingeengte oder vordefinierte Anzahl an verstärkbaren oder verstärkten Moden auf genau eine verstärkte Lasermode reduziert und damit eine sichere und zuverlässige Funktion des Halbleiterlasers in einer monomodigen Betriebsart erlaubt.

Zur Vermeidung unnötiger Wiederholungen soll im Hinblick auf die Vorteile und vorteilhaften Wirkungen sowie im Hinblick auf die Merkmale der Vorrichtung des Halbleiterlasers auf die oben beschriebene Ausgestaltung des erfindungsgemäßen Verfahrens und dessen vorteilhafte Ausführungsformen verwiesen werden. Mit anderen Worten ausgedrückt, sollen verfahrensmäßig offenbarte Merkmale auch als gegenständliche Merkmale oder Vorrichtungsmerkmale offenbart gelten und umgekehrt.

Gemäß einer ersten vorteilhaften Ausführungsform des Halbleiterlasers kann vorgesehen sein, dass das optische Element in die Facettenschichtstruktur eingebettet ist oder auf der Facettenschichtstruktur angeordnet oder als Facettenschichtstruktur ausgebildet ist. Dadurch kann sowohl der geforderte Maximalabstand vom Ende der Lateralstrukturschicht als auch die gewünschte Beeinflussung des effektiven Brechungsindex der gesamten Laserkavität und damit der Phasenlage der verstärkbaren Lasermoden vorteilhaft erreicht werden.

Es ist vorgesehen, dass das optische Element meta-optische Metallstrukturen aufweist. Die meta-optischen Metallstrukturen sind auf einer Facettenschichtstruktur so ausgebildet werden, dass insbesondere die die Phasenlage definierende Wirkung des optischen Elements zum Tragen kommt.

Ebenfalls kann vorteilhaft vorgesehen sein, dass das optische Element metallische und/oder organische dreidimensionale Strukturen aufweist, die bevorzugt in einem Zwei-Photonen-Polymerisationsverfahren selektiv aus einer flüssigen oder viskosen Vorstufe (Precursor) verfestigt werden. Auch derartige Strukturen, insbesondere dreidimensionale Strukturen, eignen sich gut zur Einstellung der Phasenlage der Laserstrahlung oder der verstärkbaren Lasermoden und können sicher und präzise, beispielsweise auf einer Facettenschichtstruktur, ausgebildet werden. Bei entsprechenden Strukturen kann auch von gedruckten Strukturen gesprochen werden, selbst wenn es sich bei dem Verfahren eher um ein additives Herstellungsverfahren als um ein klassisches Druckverfahren handelt. Weiterhin vorteilhaft kann vorgesehen sein, dass das optische Element Dielektrische- und/oder Spiegelschichtstrukturen aufweist. Die besagten Strukturen sind im Bereich der Halbleiteroptik hinlänglich bekannt und können neben ihrer Funktion als Spiegel, Filter oder dergleichen in vorteilhafter Weise auch als optisches Element im Sinne der vorliegenden Erfindung eingesetzt werden, die dann in erster Linie oder insgesamt zur präzisen Einstellung der Phasenlage der verstärkbaren Lasermoden in einem bestimmten Abstand zum Ende der Lateralstrukturschicht dienen.

Weiterhin kann vorteilhaft vorgesehen sein, dass das optische Element im Bereich der Mehrschichtstruktur, bevorzugt im Bereich des Wellenleiterstegs oder im Bereich zwischen einem Wellenleitersteg und einem Kavitätsende, ausgebildet ist. Im Gegensatz zu einer Ausbildung im Bereich der Facettenschichtstrukturen ist bei einer Ausbildung im Bereich der Mehrschichtstruktur eine Ausdehnung zumindest auch parallel zur Schichtausbreitungsebene vorgesehen. Dies bedeutet jedoch im Umkehrschluss gerade nicht, dass keine Ausbreitung in Richtung senkrecht zur Schichtausbreitungsebene vorgesehen sein kann. Vielmehr können die optischen Elemente im Bereich der Mehrschichtstruktur auch als dreidimensionale Strukturen vorliegen, die sich dann bevorzugt im Bereich des Wellenleitersteg oder zwischen Wellenleitersteg und physischem Kavitätsende sowohl über einen Bereich in der Schichtausbreitungsebene erstrecken als auch über einen Bereich senkrecht zur Schichtausbreitungsebene.

Bevorzugt kann das optische Element als aktives oder passives Phasensegment ausgebildet sein, welches insbesondere auf oder an dem Wellenleitersteg angeordnet ist. Das Phasensegment kann durch eine Wärmeentwicklung aufgrund eines elektrischen Stroms eine Beeinflussung der Phasenlage über eine Beeinflussung des effektiven Brechungsindex herbeiführen. Die Wirkung des Phasensegments kann dabei ohne Probleme so genau dimensioniert werden, dass für das optische Element und der Lateralstrukturschicht der Abstand mit der Präzision von $\min|d - m\cdot\lambda_{eff}/2| \leq \lambda_{eff}/4$ gegeben ist.

Ebenfalls vorteilhaft kann vorgesehen sein, dass das optische Element als Ionenimplantationsbereich der Mehrschichtstruktur ausgebildet ist.

Beispielsweise lässt sich durch einen entsprechenden Ionenimplantationsbereich eine Modulation des Brechungsindex lokal bewirken, der sich dann auch auf den effektiven Brechungsindex der gesamten Laserkavität auswirkt und somit zur Phasendefinition der verstärkten oder verstärkbaren Lasermoden beiträgt. Auch ein Ionenimplantationsbereich kann in erfindungsgemäßer Weise unter Einhaltung des Abstands d mit der Präzision $\min|d - m\cdot\lambda_{eff}/2| \leq \lambda_{eff}/4$ zu einem Ende der Lateralstrukturschicht ausgebildet werden.

Gleichermaßen vorteilhaft kann das optische Element auch als Bereich in der Mehrschichtstruktur mit photonischen Kristallen ausgebildet sein. Auch kann vorteilhaft vorgesehen sein, dass das optische Element als Bestandteil eines photonisch integrierten Schaltkreises ausgebildet ist. Dieser kann beispielsweise durch an sich bekannte Maskierungs-, Belichtungs- und Ätzverfahren in der Mehrschichtstruktur, beispielsweise zwischen einem Ende oder direkt im Anschluss eines Wellenleiterstegs und einem physischen Kavitätsende ausgebildet werden. Außerdem kann beispielsweise eine Beheizung oder eine aktive Temperatursteuerung eines entsprechenden Bestandteils des photonisch integrierten Schaltkreises vorgesehen sein, um eine noch bessere Definition der Phasenlage der verstärkbaren Lasermoden zu erreichen.

Beispiele und vorteilhafte Weiterbildungen der vorliegenden Erfindung ergeben sich aus den beigefügten, rein schematischen Zeichnungen.

Es zeigen:

**Fig. 1** eine schematische Darstellung der Funktionsweise des erfindungsgemäßen Halbleiterlasers;

**Fig. 2** eine beispielhafte schematische Darstellung eines erfindungsgemäßen Halbleiters in einer perspektivischen Ansicht;

**Fig. 3** eine schematische Darstellung des elektrischen Feldes der Lichtmode eines erfindungsgemäßen Halbleiterlasers.

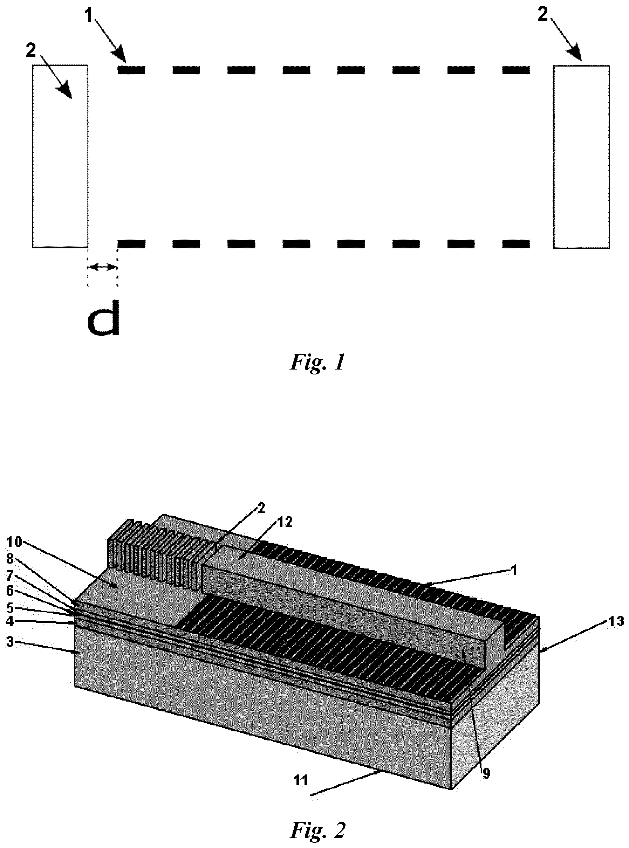

**Fig. 1** zeigt in einer Draufsicht auf eine Schichtausbreitungsebene die grundsätzliche Funktionalität oder die grundsätzliche Anordnung des erfindungsgemäßen optischen Elements 2 gegenüber einer Lateralstrukturschicht 1. Die nur angedeutete Lateralstrukturschicht 1 kann aus parallelen Stegen, beispielsweise eines metallischen Materials, als sogenannte DFB-Struktur oder Distributed-Feedback-Struktur ausgebildet sein, wobei in der Darstellung der **Fig. 1** nur entsprechende Striche zur Symbolisierung der Stege eingezeichnet sind. Gemäß jüngsten Erkenntnissen kann auch eine nicht aus parallelen Stegen bestehende sondern in zwei Raumrichtungen optimierte Lateralstrukturschicht zu einer Verbesserung von Eigenschaften eines Halbleiterlasers führen.

Dementsprechend soll unter der Lateralstrukturschicht nicht ausschließlich eine Anordnung von parallelen, bevorzugt metallischen Stegen mit einem gleichmäßigen Abstand zur Erzeugung eines periodischen Gitters verstanden werden, sondern allgemein Strukturschichten, die zumindest auch eine Grundauswahl von sehr vielen in einer Laserkavität verstärkbaren Lasermoden bewirkt.

In der **Fig. 1** sind zwei Reihen von Stegen der Lateralstrukturschicht 1 angedeutet. Zwischen diesen könnte ein in der **Fig. 1** nicht dargestellter Wellenleitersteg angeordnet sein. Mit einem Abstand d zum Ende der Lateralstrukturschicht 1 befindet sich das erfindungsgemäße optische Element 2, wobei der Abstand d höchstens der Hälfte der effektiven Wellenlänge der gewünschten Laserstrahlung beträgt. Dadurch wirkt das optische Element längendefinierend auf die Laserkavität. Weiterhin wird durch den präzise eingestellten Abstand d die Erzeugung und Verstärkung von Schwebungsmoden effektiv unterdrückt. Außerdem wird durch die geeignete Ausbildung des optischen Elements im Abstand d, nämlich unter Einstellung des effektiven Brechungsindex der gesamten Laserkavität unter Berücksichtigung des optischen Elements 2 eine genaue Phasenlage der verstärkbaren Lasermoden definiert, so dass schlussendlich nur eine einzige Lasermode verstärkt und ausgekoppelt wird und somit eine monomodige Betriebsart des Lasers ermöglicht wird.

Im Beispiel der **Fig. 1** sind an beiden Enden der Lateralstrukturschicht 1 jeweils ein optisches Element 2 angeordnet. Eine derartige Anordnung kann vorteilhaft sein, muss jedoch nicht realisiert werden. Beispielsweise kann auch ein einzelnes optisches Element 2 ausreichen, um die Phasenlage der verstärkten Lasermoden zu bestimmen und Schwebungsmoden zu unterdrücken oder zu verhindern.

**Fig. 2** zeigt beispielhaft und schematisch eine perspektivische Ansicht einer Ausführungsform eines erfindungsgemäßen Halbleiters. Der Halbleiterlaser umfasst dabei ein Substrat 3, auf dem epitaktisch eine für die Erzeugung und Auskopplung von Laserstrahlen taugliche Schichtstruktur oder Mehrschichtstruktur 4 - 8 aufgebracht ist.

Beispielsweise kann die Mehrschichtstruktur 4 - 8 zur Ausbildung eines Halbleiterlasers, beispielsweise eines Interband- oder Quantenkaskadenlasers, dienen. Die Mehrschichtstruktur 4 - 8 umfasst eine aktive Zone 6, die von einer oberen und einer unteren Wellenleiterschicht 5, 7 umgeben ist, welche wiederum in eine obere und untere Mantelschicht 4, 8 eingebettet sind. Aus der oberen Mantelschicht 8 wird im Bereich von Materialabtragsbereichen 10 durch ein Materialabtragungsverfahren ein Wellenleitersteg 9 ausgebildet. Die Kontaktschichten 11, 12 dienen zur Strominjektion.

Neben dem Wellenleitersteg 9 wird durch das Materialabtragungsverfahren auch das erfindungsgemäße optische Element 2 gebildet. Im Beispiel der **Fig. 2** in Form einer Spiegel-Schichtstruktur, nämlich in Form eines Distributed Bragg Reflectors, der einerseits die in der **Fig. 1** bereits schematisch dargestellte Anordnung, insbesondere den in der **Fig. 1** dargestellten Abstand d zum Ende der Lateralstrukturschicht 1, aufweist und darüber hinaus die Phasenlage der verstärkten oder verstärkbaren Lasermoden definiert und damit zur weiteren Modenselektion, bis hinauf genau eine Lasermode, beiträgt. Das optische Element 2 ist im Beispiel der

**Fig. 2** im Bereich der Mehrschichtstruktur 4 bis 8 angeordnet und zwar in Längsrichtung des Wellenleiterstegs 9 zwischen einem Ende des Wellenleiterstegs 9 und einem Ende der Laserkavität.

Alternativ oder zusätzlich kann auch vorgesehen sein, dass das optische Element 2 im Bereich einer Facette 13 angeordnet ist. Dabei kann vorgesehen sein, dass das optische Element 2 entweder in eine Facettenschichtstruktur, die in der **Fig. 2** selbst nicht dargestellt ist, eingebettet ist, oder aber, in Längsrichtung des Wellenleiterstegs 9 auf die Facettenschichtstruktur außen aufgebracht wird. Wie am rechten Ende der Laserkavität gemäß **Fig. 2** erkennbar ist, kann die Lateralstrukturschicht 1 ohne Probleme bis an das Kavitätsende herangeführt oder ausgebildet werden, so dass auch bei einer Ausbildung des optischen Elements 2 im Bereich der Facette des Halbleiterlasers, insbesondere auf einer Facettenschichtstruktur oder innerhalb einer Facettenschichtstruktur der erfindungsgemäße Abstand d der gewünschten Lasermode gut eingehalten werden kann. Denn die Facettenschichtstruktur, die ansonsten zur Optimierung oder Einstellung der Laserschwelle und/oder der Ausgangsleistung vorgesehen wird, beträgt in der Regel nur eine Gesamtstärke von wenigen 10 bis einigen 100 Nanometern. Besonders bevorzugt kann sogar vorgesehen sein, dass das optische Element 2 derart in die Facettenschichtstruktur eingebracht, insbesondere integriert, wird, dass die ansonsten vorgesehenen Schichten der Facettenschichtstruktur nur in ihren Eigenschaften und/oder in ihrer Reihenfolge angepasst werden, so dass mit den Verfahrensschritten zur Ausbildung der Facettenschichtstruktur auch gleichzeitig das erfindungsgemäße optische Element 2 ausgebildet werden kann.

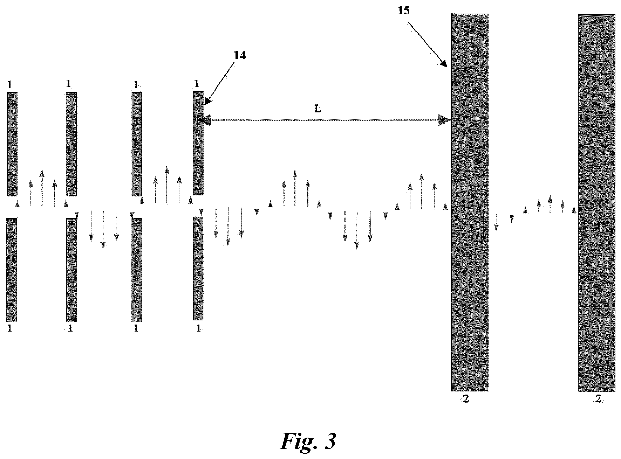

Fig. 3 zeigt eine schematische Darstellung des elektrischen Feldes E der Lichtmode eines erfindungsgemäßen Halbleiterlasers. Die Pfeile repräsentieren die Feldstärke E und Richtung des elektrischen Feldes der Lichtmode zu einem festen Zeitpunkt. Der Abstand d zwischen dem Ende 14 des wellenlängenselektiven Elementes oder der Lateralstrukturschicht 1 und dem Beginn 15 eines erfindungsgemäßen optischen Elements 2 in Form eines DBR-Spiegels, der durch den ersten Übergang von links von höher auf niedriger brechendes Medium bestimmt ist, ist im Optimalfall erfindungsgemäß ein ganzzahliges Vielfaches der halben Wellenlänge im Medium. Das Beispiel zeigt vier halbe Wellenlängen im Medium. Erfindungsgemäß wird also die Phasenlage zwischen dem wellenlängenselektiven Element oder der Lateralstrukturschicht 1 und dem DBR-Segment oder optischen Element 2 so angepasst, dass beide Elemente bei der gewünschten Wellenlänge in Phase sind. Dies wird durch die geforderte Genauigkeit der erfindungsgemäßen Bedingung $\min|d - m \cdot \lambda_{eff}/2| \leq \lambda_{eff}/4$ ausreichend gewährleistet.

**Patentansprüche**

1. Verfahren zur Herstellung eines Halbleiterlasers umfassend die Verfahrensschritte:

   - Aufbringen einer Mehrschichtstruktur (4 - 9) auf einem Halbleitersubstrat (3), wobei die Schichten der Mehrschichtstruktur (4 - 9) parallel zu einer durch eine Oberfläche des Halbleitersubstrats (3) definierten Schichtausbreitungsebene verlaufen und wobei das Aufbringen der Mehrschichtstruktur (4 - 9) zumindest das Erzeugen einer aktiven Region umfasst;
   - Abtragen von Material der Mehrschichtstruktur (4 - 9) in zumindest zwei voneinander getrennten Materialabtragsbereichen (10), wobei der Materialabtrag im Wesentlichen senkrecht zur Schichtausbreitungsebene erfolgt und dadurch ein Wellenleitersteg (9) gebildet wird;
   - Erzeugen von einer Isolationsschicht auf zumindest den Materialabtragsbereichen (10);
   - Erzeugen einer Lateralstrukturschicht (1), zumindest in den Materialabtragsbereichen (10), durch die eine Grundauswahl der durch stimulierte Emission verstärkten oder verstärkbaren Lasermoden erfolgt;
   - Erzeugen von senkrecht zur Schichtausbreitungsebene in Längsrichtung des Wellenleiterstegs (9) an einem Kavitätsende oder an zwei gegenüberliegenden Kavitätsenden angeordneten Facettenschichtstrukturen zur Reflexion und/oder Auskopplung von Laserstrahlung,

   **gekennzeichnet durch**

   - Erzeugen eines optischen Elements (2) zur Definition der Phasenlage der verstärkten oder verstärkbaren Lasermoden, wobei das Erzeugen des optischen Elements (2) die Ausbildung von meta-optischen Metallstrukturen auf einer der Facettenschichtstrukturen umfasst und wobei das optische Element (2) derart erzeugt wird, dass dieses in Längsrichtung des Wellenleiterstegs (9) einen Abstand d zu einem Ende (14) der Lateralstrukturschicht (1) aufweist, der die Bedingung $\min|d - m \cdot \lambda_{eff}/2| \leq \lambda_{eff}/4$ erfüllt, wobei m eine natürliche Zahl ( $m \in \mathbb{N}$ ) und $\lambda_{eff}$ die

   effektive Wellenlänge im Material ist.

2. Verfahren nach Anspruch 1,
   **dadurch gekennzeichnet,**
   **dass** das optische Element (2) zusammen mit der Ausbildung der Facettenschichtstrukturen erzeugt wird oder im Anschluss an die Ausbildung der Facettenschichtstruktur auf dieser erzeugt wird, wobei insbesondere das optische Element (2) durch eine Variation von Schichten und/oder Schichteigenschaften von Schichten der Facettenschichtstruktur erzeugt wird, die ansonsten zur Optimierung und/oder Einstellung einer Laserschwelle oder einer Ausgangsleistung vorgesehen sind.

3. Verfahren nach Anspruch 1 oder 2,
   **dadurch gekennzeichnet,**
   **dass** die Erzeugung des optischen Elements (2) die Ausbildung von metallischen und/oder organischen dreidimensionalen Strukturen umfasst, die bevorzugt in einem Zwei-Photonen-Polymerisationsverfahren selektiv aus einer flüssigen oder viskosen Vorstufe verfestigt werden.

4. Verfahren nach einem der Ansprüche 1 bis 3,
   **dadurch gekennzeichnet,**
   **dass** die Erzeugung des optischen Elements (2) die Ausbildung von dielektrischen und/oder Spiegel-Schichtstrukturen unter Berücksichtigung der Beeinflussung der Phasenlage der verstärkten oder verstärkbaren Lasermoden umfasst.

5. Verfahren nach einem der Ansprüche 1 bis 4, wobei ein weiteres optisches Element (2) zur Definition der Phasenlage der verstärkten oder verstärkbaren Lasermoden erzeugt wird, wobei das weitere optische Element (2) derart erzeugt wird, dass dieses in Längsrichtung des Wellenleiterstegs (9) einen Abstand d zu einem Ende (14) der Lateralstrukturschicht (1) aufweist, der die Bedingung $\min|d - m \cdot \lambda_{eff}/2| \leq \lambda_{eff}/4$ erfüllt, wobei m eine natürliche Zahl ( $m \in \mathbb{N}$ ) und $\lambda_{eff}$ die effektive Wellenlänge im Material ist und wobei das weitere optische Element (2) im Bereich der Mehrschichtstruktur (4 - 9), bevorzugt im Bereich des Wellenleiterstegs (9) oder im Bereich zwischen einem Wellenleitersteg (9) und einem Kavitätsende, ausgebildet wird.

6. Verfahren nach Anspruch 5,
   **dadurch gekennzeichnet,**
   **dass** das weitere optische Element (2) durch Ionenimplantation in die Mehrschichtstruktur (4 - 9) oder durch die Erzeugung photonischer Kristalle in der Mehrschichtstruktur (4 - 9) oder durch die Erzeugung photonisch integrierter Schaltkreise ausgebildet wird.

7. Verfahren nach einem der Ansprüche 1 bis 6,

**dadurch gekennzeichnet,**
**dass** eine Vielzahl von Halleiterlasern benachbart zueinander oder aneinander angrenzend auf einem gemeinsamen Halbleitersubstrat (3) ausgebildet werden und eine an die Ausbildung anschließende Vereinzelung der Halbleiterlaser, bevorzugt über eine Bildung einer Array- oder Matrixanordnung mit mehreren nebeneinander angeordneten und miteinander verbundenen Halbleiterlasern, insbesondere durch eine mechanische Spaltung und/oder ein Sägen, erfolgt, wobei insbesondere die Ausbildung des optischen Elements (2) für mehrere nebeneinander angeordnete Halbleiterlaser, bevorzugt für die Halbleiterlaser einer gemeinsamen Array- oder Matrixanordnung zusammen, insbesondere gleichzeitig erfolgt.

8.  Verfahren nach einem der Ansprüche 1 bis 7,
    **dadurch gekennzeichnet,**
    **dass** in Längsrichtung des Wellenleiterstegs der Abstand d so eingestellt wird, dass die Phasenlage zwischen der Lateralstruktur und dem optischen Element (2) und/oder zwischen der Lateralstruktur und dem weiteren optischen Element (2) besser als $\pi/4$ kontrolliert wird.

9.  Halbleiterlaser aufweisend

    eine Mehrschichtstruktur (4 - 9) umfassend zumindest einen Wellenleitersteg (9) und an den Wellenleitersteg (9) seitlich angrenzende Materialabtragsbereiche (10), wobei die Mehrschichtstruktur (4 - 9) auf einem Halbleitersubstrat (3) angeordnet ist und wobei durch eine Oberfläche des Halbleitersubstrats (3) eine Schichtausbreitungsebene definiert wird, wobei die Mehrschichtstruktur (4 - 9) zumindest eine aktive Region aufweist, wobei die aktive Region eine Schicht- und/oder Materialstruktur zur Ausbildung einer Laserschicht auf der Grundlage des Prinzips der stimulierten Emission aufweist, wobei zumindest in den Materialabtragsbereichen (10), bevorzugt auf einer Isolationsschicht, eine Lateralstrukturschicht (1) vorgesehen ist, durch die eine Grundauswahl der durch stimulierte Emission verstärkten oder verstärkbaren Lasermoden erfolgt, und wobei senkrecht zur Schichtausbreitungsebene in Längsrichtung des Wellenleiterstegs (9) an einem Kavitätsende oder an zwei gegenüberliegenden Kavitätsenden Facettenschichtstrukturen zur Reflexion und/oder Auskopplung von Laserstrahlung ausgebildet sind,
    **dadurch gekennzeichnet,**
    **dass** der Halbleiterlaser ein optisches Element (2) zur Definition der Phasenlage der verstärkten oder verstärkbaren Lasermoden aufweist, wobei das optische Element (2) in Längsrichtung des Wellenleiterstegs (9) einen Abstand d zu einem Ende (14) der Lateralstrukturschicht (1) aufweist, der die Bedingung $\min|d - m \cdot \lambda_{eff}/2|$ $\leq \lambda_{eff}/4$ erfüllt, wobei m eine natürliche Zahl ( $m \in \mathbb{N}$ ) und $\lambda_{eff}$ die effektive Wellenlänge im Material ist und dass das optische Element (2) auf einer der Facettenstrukturschichten angeordnete meta-optische Metallstrukturen aufweist.

10. Halbleiterlaser nach Anspruch 9,
    **dadurch gekennzeichnet,**
    **dass** das optische Element (2) in die Facettenschichtstruktur eingebettet ist oder auf der Facettenschichtstruktur angeordnet ist.

11. Halbleiterlaser nach Anspruch 9 oder 10,
    **dadurch gekennzeichnet,**
    **dass** das optische Element (2) metallische und/oder organische dreidimensionale Strukturen aufweist, die bevorzugt in einem Zwei-Photonen-Polymerisationsverfahren selektiv aus einer flüssigen oder viskosen Vorstufe verfestigt werden.

12. Halbleiterlaser nach einem der Ansprüche 9 bis 11,
    **dadurch gekennzeichnet,**
    **dass** das optische Element (2) dielektrische und/oder Spiegel-Schichtstrukturen aufweist.

13. Halbleiterlaser nach einem der Ansprüche 9 bis 12,
    **dadurch gekennzeichnet,**
    **dass** der Halbleiterlaser ein weiteres optisches Element (2) zur Definition der Phasenlage der verstärkten oder verstärkbaren Lasermoden aufweist, wobei das optische Element (2) in Längsrichtung des Wellenleiterstegs (9) einen Abstand d zu einem Ende (14) der Lateralstrukturschicht (1) aufweist, der die Bedingung $\min|d - m \cdot \lambda_{eff}/2| \leq \lambda_{eff}/4$ erfüllt, wobei m eine natürliche Zahl ( $m \in \mathbb{N}$ ) und $\lambda_{eff}$ die effektive Wellenlänge im Material ist und wobei das weitere optische Element (2) im Bereich der Mehrschichtstruktur (4 - 9), bevorzugt im Bereich des Wellenleiterstegs (9) oder im Bereich zwischen einem Wellenleitersteg (9) und einem Kavitätsende, ausgebildet ist.

14. Halbleiterlaser nach Anspruch 13,
    **dadurch gekennzeichnet,**
    **dass** das weitere optische Element (2) als Ionenimplantationsbereich der Mehrschichtstruktur (4 - 9) oder als Bereich der Mehrschichtstruktur (4 - 9) mit photonischen Kristallen oder als Bestandteil eines photonisch integrierten Schaltkreises ausgebildet ist.

15. Halbleiterlaser nach einem der Ansprüche 9 bis 14,
    **dadurch gekennzeichnet,**

**dass** in Längsrichtung des Wellenleiterstegs der Abstand d so eingestellt ist, dass die Phasenlage zwischen der Lateralstruktur und dem optischen Element (2) und/oder zwischen der Lateralstruktur und dem weiteren optischen Element (2) besser als π/4 kontrollierbar ist.

## Claims

1. A method for producing a semiconductor laser comprising the method steps:

   - applying a multilayer structure (4 - 9) on a semiconductor substrate (3), the layers of the multilayer structure (4 - 9) extending parallel to a layer extension plane defined by a surface of the semiconductor substrate (3) and the application of the multilayer structure (4 - 9) including at least the generation of an active region;
   - abrading material of the multilayer structure (4 - 9) in at least two material abrasion areas (10) separated from one another, the material being abraded substantially perpendicular to the layer extension plane, whereby a waveguide ridge (9) is formed;
   - generating an insulation layer on at least the material abrasion areas (10);
   - generating a lateral structure layer (1), at least in the material abrasion areas (10), a basic selection of the laser modes amplified or amplifiable through stimulated emission taking place via the lateral structure layer;
   - generating facet layer structures which serve for reflecting and/or decoupling laser radiation and are disposed on a cavity end or on two opposite cavity ends perpendicular to the layer extension plane in the longitudinal direction of the waveguide ridge (9), **characterized by**
   - generating an optical element (2) for defining the phasing of the amplified or amplifiable laser modes, the generation of the optical element (2) including the formation of meta-optical metal structures on one of the facet layer structures and the optical element (2) being generated in such a manner that it has a distance d to an end (14) of the lateral structure layer (1) in the longitudinal direction of the waveguide ridge (9), distance d fulfilling the condition min$|d - m \cdot \lambda_{eff}/2| \leq \lambda_{eff}/4$, m being a natural number ( $m \in \mathbb{N}$ ) and $\lambda_{eff}$ being the effective wavelength in the material.

2. The method according to claim 1, **characterized in that** the optical element (2) is generated simultaneously with the formation of the facet layer structures or on the facet layer structure in subsequence to the formation of said facet layer structure, in particular the optical element (2) being generated by a variation of layers and/or layer properties of layers of the facet layer structure, the layers and/or layer properties otherwise being intended for optimizing and/or setting a laser threshold or an output power.

3. The method according to claim 1 or 2, **characterized in that** the generation of the optical element (2) includes the formation of metallic and/or organic three-dimensional structures, which are hardened selectively from a liquid or viscous precursor preferably in a two-photon polymerization method.

4. The method according to any one of the claims 1 to 3, **characterized in that** the generation of the optical element (2) includes the formation of dielectric layer structures and/or mirror layer structures while taking into consideration the influencing of the phasing of the amplified or amplifiable laser modes.

5. The method according to any one of the claims 1 to 4,

   wherein a further optical element (2) for defining the phasing of the amplified or amplifiable laser modes is generated, the further optical element (2) being generated in such a manner that it has a distance d to an end (14) of the lateral structure layer (1) in the longitudinal direction of the waveguide ridge (9), distance d fulfilling the condition min$|d - m \cdot \lambda_{eff}/2| \leq \lambda_{eff}/4$, m being a natural number ( $m \in \mathbb{N}$ ) and $\lambda_{eff}$ being the effective wavelength in the material and
   wherein the further optical element (2) is formed in the area of the multilayer structure (4 - 9), preferably in the area of the waveguide ridge (9) or in the area between a waveguide ridge (9) and a cavity end.

6. The method according to claim 5, **characterized in that** the further optical element (2) is formed by ion implantation in the multilayer structure (4 - 9) or by generating photonic crystals in the multilayer structure (4 - 9) or by generating photonically integrated circuits.

7. The method according to any one of the claims 1 to 6, **characterized in that** a plurality of semiconductor lasers are realized to be adjacent to one another or to abut against one another on a shared semiconductor substrate (3) and **in that** the semiconductor lasers are separated in subsequence to the formation, preferably by forming an array or matrix arrangement having several adjacent and interconnected semiconductor lasers, in particular by mechanical splitting and/or sawing, the optical element (2) in particular being formed together, in particular simultaneously, for several adjacent semiconductor lasers, preferably for the semiconductor lasers of a shared array or matrix arrangement.

8. The method according to any one of the claims 1 to 7, **characterized in that** distance d is set in the longitudinal direction of the waveguide ridge such that the phasing between the lateral structure and the optical element (2) and/or between the lateral structure and the further optical element (2) is controlled better than $\pi/4$.

9. A semiconductor laser, comprising

a multilayer structure (4 - 9) comprising at least one waveguide ridge (9) and material abrasion areas (10) laterally abutting against the waveguide ridge (9), the multilayer structure (4 - 9) being disposed on a semiconductor substrate (3) and a layer extension plane being defined by a surface of the semiconductor substrate (3), the multilayer structure (4 - 9) having at least one active region, the active region having a layer structure and/or material structure for forming a laser layer based on the principle of stimulated emission, a lateral structure layer (1) being provided at least in the material abrasion areas (10), preferably on an insulation layer, a basic selection of the laser modes amplified or amplifiable via stimulated emission taking place via the lateral structure layer, and facet layer structures, which serve for reflecting and/or decoupling laser radiation, being formed on a cavity end or on two opposite cavity ends perpendicular to the layer extension plane in the longitudinal direction of the waveguide ridge (9), **characterized in that** the semiconductor laser has an optical element (2) for defining the phasing of the amplified or amplifiable laser modes, the optical element (2) having a distance d to an end (14) of the lateral structure layer (1) in the longitudinal direction of the waveguide ridge (9), distance d fulfilling the condition $\min|d - m\,\lambda_{eff}/2| \leq \lambda_{eff}/4$, m being a natural number ( $m \in \mathbb{N}$ ) and $\lambda_{eff}$ being the effective wavelength in the material and **in that** the optical element (2) has meta-optical metal structures disposed on one of the facet layer structures.

10. The semiconductor laser according to claim 9, **characterized in that** the optical element (2) is embedded in the facet layer structure or is disposed on the facet layer structure.

11. The semiconductor laser according to claim 9 or 10, **characterized in that** the optical element (2) has metallic and/or organic three-dimensional structures, which are hardened selectively from a liquid or viscous precursor preferably in a two-photon polymerization method.

12. The semiconductor laser according to any one of the claims 9 to 11, **characterized in that** the optical element (2) has dielectric layer structures and/or mirror layer structures.

13. The semiconductor laser according to any one of the claims 9 to 12, **characterized in that** the semiconductor laser comprises a further optical element (2) for defining the phasing of the amplified or amplifiable laser modes, the optical element (2) having a distance d to an end (14) of the lateral structure layer (1) in the longitudinal direction of the waveguide ridge (9), distance d fulfilling the condition $\min|d - m\cdot\lambda_{eff}/2| \leq \lambda_{eff}/4$, m being a natural number ( $m \in \mathbb{N}$ ) and $\lambda_{eff}$ being the effective wavelength in the material and the further optical element (2) being formed in the area of the multilayer structure (4 - 9), preferably in the area of the waveguide ridge (9) or in the area between a waveguide ridge (9) and a cavity end.

14. The semiconductor laser according to claim 13, **characterized in that** the further optical element (2) is realized as an ion implantation area of the multilayer structure (4 - 9) or as an area of the multilayer structure (4 - 9) having photonic crystals or as a component of a photonically integrated circuit.

15. The semiconductor laser according to any one of claims 9 to 14, **characterized in that** distance d is set in the longitudinal direction of the waveguide ridge such that the phasing between the lateral structure and the optical element (2) and/or between the lateral structure and the further optical element (2) can be controlled better than $\pi/4$.

**Revendications**

1. Procédé de fabrication d'un laser à semi-conducteur, comprenant les étapes suivantes :

- appliquer une structure (4 - 9) multicouche sur un substrat (3) semi-conducteur, les couches de la structure (4 - 9) multicouche s'étendant parallèlement à un plan d'expansion de couche défini par une surface du substrat (3) semi-conducteur, et l'application de la structure (4 - 9) multicouche comprenant au moins la production d'une région active ;

- enlever du matériau de la structure (4 - 9) multicouche dans au moins deux sections (10) d'enlèvement de matériau séparées, l'enlèvement de matériau s'effectuant considérablement perpendiculairement au plan d'expansion de couche, formant ainsi un guide d'ondes à nervure (9) ;

- générer une couche d'isolation sur au moins les sections (10) d'enlèvement de matériau ;

- générer une couche de structure (1) latérale, au moins dans les sections (10) d'enlèvement de matériau, une sélection de base des modes laser amplifiés ou amplifiables par émission stimulée se produisant via la couche de structure latérale ;

- générer des structures de couche de facette qui servent à réfléchir et/ou découpler le rayonnement laser et sont disposées sur une extrémité de cavité ou sur deux extrémités opposées de cavité perpendiculairement au plan d'expansion de couche dans la direction longitudinale du guide d'ondes à nervure (9),

**caractérisé par**

la génération d'un élément optique (2) pour définir la position de phase des modes laser amplifiés ou amplifiables, la génération de l'élément optique (2) comprenant la formation de structures métalliques méta-optiques sur l'une des structures de couche de facette et l'élément optique (2) étant généré de telle manière qu'il présente une distance d par rapport à une extrémité (14) de la couche de structure (1) latérale dans la direction longitudinale du guide d'ondes à nervure (9), la distance d satisfaisant la condi-tion min|d - m $\lambda_{(eff)}$ /2| ≤ $\lambda_{(eff)}$/4, m étant un nombre naturel ( $m \in \mathbb{N}$ ) et $\lambda_{(eff)}$ étant la longueur d'onde effective dans le matériau.

**2.** Procédé selon la revendication 1,
**caractérisé en ce que**
l'élément optique (2) est généré simultanément avec la formation des structures de couche de facette ou sur la structure de couche de facette à la suite de la formation de ladite structure de couche de facette, notamment l'élément optique (2) étant généré par une variation des couches et/ou des propriétés des couches de la structure de couche de facette, les couches et/ou les propriétés des couches étant par ailleurs destinées à optimiser et/ou à régler un seuil laser ou une puissance de sortie.

**3.** Procédé selon la revendication 1 ou la revendication 2,
**caractérisé en ce que**
la génération de l'élément optique (2) comprend la formation de structures tridimensionnelles métalliques et/ou organiques, qui sont durcies sélectivement à partir d'un précurseur liquide ou visqueux, de préférence selon un procédé de polymérisation à deux photons.

**4.** Procédé selon l'une quelconque des revendications 1 à 3,
**caractérisé en ce que**
la génération de l'élément optique (2) comprend la formation de structures de couche diélectriques et/ou de structures de couche miroirs tout en tenant compte de l'influence de la position de phase des modes laser amplifiés ou amplifiables.

**5.** Procédé selon l'une quelconque des revendications 1 à 4,
dans lequel un élément optique (2) supplémentaire destiné à définir la position de phase des modes laser amplifiés ou amplifiables est généré, l'élément optique (2) supplémentaire étant généré de telle manière qu'il présente une distance d par rapport à une extrémité (14) de la couche de structure (1) latérale dans la direction longitudinale du guide d'ondes à nervure (9), la distance d satisfaisant la condi-tion min|d - m $\lambda_{(eff)}$ /2| ≤ $\lambda_{(eff)}$/4, m étant un nombre naturel ( $m \in \mathbb{N}$ ) et $\lambda_{(eff)}$ étant la longueur d'onde effective dans le matériau et dans lequel l'élément optique (2) supplémentaire est formé dans la zone de la structure (4 - 9) multicouche, de préférence dans la zone du guide d'ondes à nervure (9) ou dans la zone entre un guide d'ondes à nervure (9) et une extrémité de cavité.

**6.** Procédé selon la revendication 5,
**caractérisé en ce que**
l'élément optique (2) supplémentaire est formé par implantation ionique dans la structure (4 - 9) multicouche ou par génération de cristaux photoniques dans la structure (4 - 9) multicouche ou par génération de circuits intégrés photoniques.

**7.** Procédé selon l'une quelconque des revendications 1 à 6,
**caractérisé en ce**
**qu'**une pluralité de lasers à semi-conducteur sont réalisés de manière à être adjacents les uns aux autres ou à être en butée les uns contre les autres sur un substrat à semi-conducteur (3) commun et **en ce que** les lasers à semi-conducteur sont séparés après la formation, de préférence en formant un réseau ou une matrice ayant plusieurs lasers à semi-conducteur adjacents et interconnectés, notamment par division mécanique et/ou sciage, l'élément optique (2) étant notamment formé ensemble, notamment simultanément, pour plusieurs lasers à semi-conducteur adjacents, de préférence pour les lasers à semi-conducteur d'un réseau ou d'une matrice commun/e.

8. Procédé selon l'une quelconque des revendications 1 à 7,
   **caractérisé en ce que**
   la distance d est réglée dans la direction longitudinale du guide d'ondes à nervure de telle sorte que la position de phase entre la structure latérale et l'élément optique (2) et/ou entre la structure latérale et l'élément optique (2) supplémentaire est contrôlée mieux que $\pi/4$.

9. Laser à semi-conducteur, comprenant

   une structure (4 - 9) multicouche comprenant au moins un guide d'ondes à nervure (9) et des sections (10) d'enlèvement de matériau bordant latéralement le guide d'ondes à nervure (9), la structure (4 - 9) multicouche étant disposée sur un substrat (3) semi-conducteur et un plan d'expansion de couche étant défini par une surface du substrat (3) semi-conducteur, la structure (4 - 9) multicouche ayant au moins une région active, la région active ayant une structure de couche et/ou de matériau pour former une couche laser basée sur le principe de l'émission stimulée, une couche de structure (1) latérale étant prévue au moins dans les sections (10) d'enlèvement de matériau, de préférence sur une couche d'isolation, une sélection de base des modes laser amplifiés ou amplifiables par émission stimulée se produisant par la couche de structure latérale, et des structures de couche de facette, qui servent à réfléchir et/ou découpler le rayonnement laser, étant formées sur une extrémité de cavité ou sur deux extrémités opposées de cavité perpendiculairement au plan d'expansion de couche dans la direction longitudinale du guide d'ondes à nervure (9),
   **caractérisé en ce que**
   le laser à semi-conducteur a un élément optique (2) pour définir la position de phase des modes laser amplifiés ou amplifiables, l'élément optique (2) présentant une distance d par rapport à une extrémité (14) de la couche de structure (1) latérale dans la direction longitudinale du guide d'ondes à nervure (9), la distance d satisfaisant la condition min$|d - m\,\lambda_{eff}/2| \leq \lambda_{eff}/4$, m étant un nombre naturel ( $m \in \mathbb{N}$ ) et $\lambda_{eff}$ étant la longueur d'onde effective dans le matériau et **en ce que** l'élément optique (2) a des structures métalliques méta-optiques disposées sur l'une des structures de couche de facette.

10. Laser à semi-conducteur selon la revendication 9,
    **caractérisé en ce que**
    l'élément optique (2) est noyé dans la structure de couche de facette ou est disposé sur la structure de couche de facette.

11. Laser à semi-conducteur selon la revendication 9 ou la revendication 10,
    **caractérisé en ce que**
    l'élément optique (2) a des structures tridimensionnelles métalliques et/ou organiques, qui sont durcies sélectivement à partir d'un précurseur liquide ou visqueux, de préférence selon un procédé de polymérisation à deux photons.

12. Laser à semi-conducteur selon l'une quelconque des revendications 9 à 11,
    **caractérisé en ce que**
    l'élément optique (2) a des structures de couche diélectriques et/ou des structures de couche miroirs.

13. Laser à semi-conducteur selon l'une quelconque des revendications 9 à 12,
    **caractérisé en ce que**
    le laser à semi-conducteur comprend un élément optique (2) supplémentaire pour définir la position de phase des modes laser amplifiés ou amplifiables, l'élément optique (2) ayant une distance d par rapport à une extrémité (14) de la couche de structure (1) latérale dans la direction longitudinale du guide d'ondes à nervure (9), la distance d satisfaisant la condition min$|d - m\cdot\lambda_{eff}/2| \leq \lambda_{eff}/4$, m étant un nombre naturel ( $m \in \mathbb{N}$ ) et $\lambda_{(eff)}$ étant la longueur d'onde effective dans le matériau, et l'élément optique (2) supplémentaire étant formé dans la zone de la structure (4 - 9) multicouche, de préférence dans la zone du guide d'ondes à nervure (9) ou dans la zone entre un guide d'ondes à nervure (9) et une extrémité de cavité.

14. Laser à semi-conducteur selon la revendication 13,
    **caractérisé en ce que**
    l'élément optique (2) supplémentaire est réalisé sous la forme d'une zone d'implantation ionique de la structure (4 - 9) multicouche ou sous la forme d'une zone de la structure (4 - 9) multicouche ayant des cristaux photoniques ou sous la forme d'un composant d'un circuit photonique intégré.

15. Laser à semi-conducteur selon l'une quelconque des revendications 9 à 14,
    **caractérisé en ce que**
    la distance d est définie dans la direction longitudinale du guide d'ondes à nervure de telle manière que la position de phase entre la structure latérale et l'élément optique (2) et/ou entre la structure latérale et l'élément optique (2) supplémentaire peut être contrôlée mieux que $\pi/4$.

*Fig. 1*

*Fig. 2*

*Fig. 3*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0984535 B1
- EP 1283571 A1
- JP 2001291929 A

- US 20170299822 A1
- WO 2005124951 A1

**In der Beschreibung aufgeführte Nicht-Patentliteratur**

- **N. YU et al.** *Optics Express*, 2008, vol. 16 (24), 19447